(19) Europäisches Patentamt
European Patent Office
Office européen des brevets

(11) **EP 2 417 645 B1**

(12) **FASCICULE DE BREVET EUROPEEN**

(45) Date de publication et mention
de la délivrance du brevet:
**02.08.2017 Bulletin 2017/31**

(21) Numéro de dépôt: **10717189.4**

(22) Date de dépôt: **09.04.2010**

(51) Int Cl.:
*B81B 3/00* *(2006.01)*       *H01L 41/09* *(2006.01)*
*G01L 1/00* *(2006.01)*       *G01L 9/00* *(2006.01)*
*H01L 27/20* *(2006.01)*       *H03H 3/007* *(2006.01)*
*H03H 9/02* *(2006.01)*

(86) Numéro de dépôt international:
**PCT/FR2010/000299**

(87) Numéro de publication internationale:
**WO 2010/116061 (14.10.2010 Gazette 2010/41)**

(54) **DISPOSITIF MICROELECTROMECANIQUE PIEZOELECTRIQUE**

PIEZOELEKTRISCHE MIKROELEKTROMECHANISCHE ANORDNUNG

PIEZOELECTRIC MICROELECTROMECHANICAL DEVICE

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **10.04.2009 FR 0901794**

(43) Date de publication de la demande:
**15.02.2012 Bulletin 2012/07**

(73) Titulaire: **Centre National de la Recherche Scientifique**
**75016 Paris (FR)**

(72) Inventeurs:
• **FAUCHER, Marc**
**F-59000 Lille (FR)**
• **THERON, Didier**
**59100 Roubaix (FR)**

• **GAQUIERE, Christophe**
**F-59650 Villeneuve d'Ascq (FR)**

(74) Mandataire: **Gevers & Orès**
**41 avenue de Friedland**
**75008 Paris (FR)**

(56) Documents cités:
**WO-A-2007/131796        US-A1- 2005 151 530**
**US-A1- 2007 176 211        US-A1- 2007 287 233**
**US-B1- 6 344 417**

• **PEARTON S J ET AL: "TOPICAL REVIEW; GaN-based diodes and transistors for chemical, gas, biological and pressure sensing; Topical Review" JOURNAL OF PHYSICS: CONDENSED MATTER, INSTITUTE OF PHYSICS PUBLISHING, BRISTOL, GB, vol. 16, no. 29, 28 juillet 2004 (2004-07-28), pages R961-R994, XP020059871 ISSN: 0953-8984**

**Description**

L'invention porte sur un dispositif microélectromécanique dont le fonctionnement est basé sur un effet piézoélectrique. Plus particulièrement, elle porte sur un dispositif microélectromécanique constitué au moins en partie par un matériau semiconducteur et comportant un transistor à effet de champ fonctionnant comme capteur de contraintes mécaniques. De préférence, un dispositif microélectromécanique selon l'invention peut être réalisé en matériaux semi-conducteurs piézoélectriques, tels que des semi-conducteurs de type III-N (nitrures d'éléments du groupe III) ou les semi-conducteurs à base de GaAs.

Les dispositifs et systèmes microélectromécaniques (dits « MEMS » pour Micro-Electro-Mechanical Systems ») ont connu un développement important dans les dernières décennies. Fabriqués à l'aide de techniques empruntées à la microélectronique, ces dispositifs comportent typiquement des éléments mécaniques de dimensions submillimétriques (poutres encastrées, membranes...), ainsi que des actionneurs pour mettre en mouvement lesdits éléments mécaniques et/ou des capteurs pour détecter le mouvement desdits éléments mécaniques.

Lorsque les dimensions caractéristiques des éléments mécaniques sont inférieures au micromètre, on parle parfois de dispositifs et systèmes nanoélectromécaniques (dits « NEMS » pour Nano-Electro-Mechanical Systems »). Dans la suite, les expressions « MEMS » et « dispositif micromécaniques » seront utilisées dans un sens large, incluant les dispositifs et systèmes nanoélectromécaniques (NEMS).

La détection du mouvement à l'échelle micromécanique se heurte encore à des difficultés importantes, qui limitent les potentialités des systèmes microélectromécaniques. Cela est particulièrement vrai pour les applications à haute fréquence, c'est à dire pour la détection d'oscillations ou vibrations à des fréquences supérieures ou égales à 100 kHz environ, voire jusqu'à quelques GHz.

Les difficultés technologiques sont essentiellement dues au fait que l'énergie mécanique transmise par un élément micromécanique à un capteur est généralement très petite. En outre, la valeur du « facteur de jauge », quantifiant le couplage mécanique - électrique obtenu à l'aide d'effets capacitifs ou piézoélectriques (les plus couramment utilisés), est généralement faible, de l'ordre de $10^{-6}$. Dans ces conditions, les signaux générés par les capteurs sont souvent très faibles par rapport au bruit et aux couplages parasites. Par exemple, dans le cas d'un MEMS de type résonant comportant un actionneur forçant l'oscillation d'un élément vibrant, il est parfois difficile d'assurer que le signal provenant d'un capteur associé audit élément vibrant soit réellement représentatif du mouvement de ce dernier, et ne soit pas dû principalement à un couplage parasite, de nature électrique ou électromagnétique, entre le capteur et l'actionneur.

Le concept de transistor à grille résonante, connu de l'article de H. C. Nathanson et al. « The resonant gate transistor », IEEE Transactions on Electron Devices, Vol. ED-14, N°3, pages 117 (1967) permet d'amplifier le couplage mécanique - électrique, en convertissant un déplacement mécanique en une variation du courant drain-source d'un transistor à effet de champ. Cependant, l'utilisation de ce principe est limitée par des difficultés technologiques liées au contrôle des états électroniques de surface. Cela est dû au fait que le dispositif est basé sur un entrefer (espace rempli d'air) entre le canal et la grille mobile. De part et d'autre de l'entrefer peuvent se trouver des charges de surface qui sont dépendantes de l'environnement. Les matériaux III-V évitent ce problème car les interactions piézoélectriques misent en jeu restent à l'intérieur de la matière.

Les matériaux de type III-N, c'est à dire les nitrures des éléments du groupe III, et en particulier AlGaN et GaN, sont particulièrement intéressants pour des applications microélectromécaniques car ils sont à la fois semi-conducteurs et piézoélectriques.

L'article de Y. Cordier et al. « AlGaN/GaN HEMTs on resistive si(111) substrate grown by gas-source MBE », Electronics Letters, Vol. 38, N°2, pages 91-92, 17 janvier 2002, décrit la fabrication d'une hétérostructure par dépôt de couches épitaxiales de AlGaN/GaN sur un substrat de silicium, et l'intégration d'un transistor à haute mobilité électronique (HEMT : « High-electron mobility transistor ») dans une telle hétérostructure.

Les articles :

- V. Cimalla, J. Pezoldt et O. Ambacher, « Group III nitride and SiC based MEMS and NEMS : materials properties, technologies and applications », Journal of Physics D : Applied Physics, 40 (2007), pages 6386 - 6434 ; et
- F. Niebelschütz et al. « AlGaN/GaN-based MEMS with two-dimensional electron gas for novel sensor applications », Physica Status Solidi (c) Volume 5 Issue 6, 2008, pages 1914 - 1916 ;

ainsi que les documents WO2004/083110 et US2007/0176211 divulguent des MEMS de type à micro-poutre vibrante, réalisés en hétérostructure AlGaN/GaN, dans lesquels les mouvements oscillatoires de la micro-poutre sont détectés à l'aide d'un transistor de type HEMT intégré à l'hétérostructure.

L'invention vise à modifier l'architecture de ces dispositifs micromécaniques connus de l'art antérieur de manière à optimiser leurs performances, notamment en termes de facteur de jauge et d'impédance, en particulier dans des applications à hautes fréquences

L'invention repose en particulier sur l'utilisation une structure d'interconnexion du transistor de détection ayant une géométrie inhabituelle, de type tridimensionnel. De préférence, cette structure d'interconnexion comporte un guide d'onde coplanaire constituée par trois pistes conductrices reliées à des électrodes de drain et de source dudit transistor.

Une structure d'interconnexion selon l'invention comporte au moins deux pistes conductrices, connectées à deux électrodes respectives du transistor de détection, qui se chevauchent sans contact électrique entre elles. Le chevauchement de pistes connectées à des électrodes respectives d'un même transistor est généralement considéré comme une erreur de conception en microélectronique, en raison des couplages capacitifs parasites qu'il introduit. Cependant, les présents inventeurs se sont rendu compte du fait qu'une telle géométrie présente des avantages importants dans l'application considérée ici, en raison des contraintes géométriques particulières imposées par la présence d'un élément micromécanique suspendu (micro-poutre ou membrane), tandis que, d'une manière inattendue, les couplages capacitifs peuvent être maintenus à des niveaux tout à fait acceptables.

Un objet de l'invention est donc un dispositif microélectromécanique comportant : un substrat ; une première couche d'un matériau piézoélectrique, déposée sur une surface dudit substrat ; une deuxième couche d'un matériau semiconducteur, déposée sur ladite première couche ; au moins un élément suspendu, formé par des prolongements desdites couches s'étendant au-delà d'un bord dudit substrat ; et un transistor à effet de champ intégré à ladite deuxième couche et à son prolongement, ayant au moins un canal s'étendant au moins en partie à l'intérieur dudit élément suspendu, comportant des électrodes connectées à des pistes conductrices s'étendant au-dessus de ladite deuxième couche et dont au moins une passe par-dessus ledit bord du substrat ; caractérisé en ce qu'au moins deux pistes conductrices connectées à deux électrodes respectives du transistor à effet de champ se chevauchent, sans contact électrique entre elles, de manière à former une structure d'interconnexion tridimensionnelle.

De préférence, en particulier dans les applications à haute fréquence, au moins une électrode de drain et une électrode de source dudit transistor à effet de champ peuvent être connectées à des pistes électriques formant un guide d'onde de type coplanaire ou microstrip.

Selon différents modes de réalisation de l'invention :

- Ledit élément suspendu peut comporter un axe de symétrie qui est aussi un axe de symétrie pour les pistes d'interconnexion s'étendant sur ledit élément suspendu.
- Le dispositif microélectromécanique peut comporter également une troisième couche, réalisée en un troisième matériau diélectrique, recouvrant au moins partiellement ladite deuxième couche et sur laquelle est déposée au moins une desdites pistes électriques, des vias étant pratiqués dans ladite troisième couche pour permettre l'interconnexion de ladite ou de chaque dite piste électrique avec les électrodes du transistor à effet de champ.

- Ledit élément suspendu peut présenter une forme choisie entre : une poutre, un disque ou une plaque. Plus particulièrement il peut présenter une forme choisie entre : une poutre encastrée à ses deux extrémités et un disque ou plaque encastré sur tout son périmètre, ledit transistor à effet de champ étant formé au niveau d'une partie d'encastrement dudit élément.
- Le dispositif microélectromécanique peut comporter également un actionneur réalisé au niveau d'une partie dudit élément suspendu autre que celle portant ledit transistor, ledit actionneur étant adapté pour exciter un mode de vibration de la poutre dans une direction perpendiculaire à la surface dudit substrat. Avantageusement, cet actionneur peut comporter des électrodes en contact électrique avec deux faces opposées de ladite première couche, si cette dernière est réalisée en matériau semi-conducteur piézoélectrique. Au moins une desdites électrodes de l'actionneur peut être connectée à une piste conductrice passant au-dessus des pistes conductrices d'interconnexion des électrodes du transistor.

Il n'est pas essentiel que l'actionneur soit disposé à proximité de la région d'encastrement de l'élément suspendu.

- Ladite première couche peut présenter une épaisseur supérieure à celle de ladite deuxième couche.
- Ladite première couche peut être réalisée en un matériau semiconducteur piézoélectrique différent de celui constituant la deuxième couche, de telle manière que l'interface entre la première et la deuxième couche forme une hétérostructure semiconductrice. Ladite deuxième couche peut également être réalisée en matériau semiconducteur piézoélectrique, différent de celui constituant la première couche. Dans ce cas, un gaz bidimensionnel de porteurs peut être formé à l'interface entre la première et la deuxième couche. Plus particulièrement, la première et la deuxième couches peuvent être réalisées en des matériaux semi-conducteurs piézoélectriques différents, de type III-N, tels que AlGaN et GaN.

- Le transistor à effet de champ d'un dispositif microélectromécanique selon un premier mode de réalisation de l'invention comporte : une première électrode de forme allongée, s'étendant sur l'élément suspendu dans une direction sensiblement perpendiculaire à celle dudit bord du substrat, connectée à une piste conductrice centrale d'un guide d'onde s'étendant au-dessus de la deuxième couche ; deux deuxièmes électrodes de forme allongée, s'étendant sur l'élément suspendu dans une direction sensiblement perpendiculaire à celle dudit bord du substrat, disposées de part et d'autre de la première électrode et connectées à des pistes conductrice latérales respectives dudit guide d'onde, deux canaux du transistor étant délimités par la première et les deuxièmes électrodes ; et deux électrodes de grille de forme allongée, s'étendant sur l'élément suspendu au dessus de canaux respectifs du transistor, séparés de ces derniers par des couche isolantes et connectées à au moins une piste conductrice chevauchant, sans contact électrique, au moins la piste centrale et une piste latérale dudit guide d'onde.

- Le transistor à effet de champ d'un dispositif microélectromécanique selon un deuxième mode de réalisation de l'invention comporte : une première électrode de forme allongée, s'étendant sur l'élément suspendu dans une direction sensiblement perpendiculaire à celle dudit bord du substrat, connectée à une piste conductrice centrale d'un guide d'onde s'étendant au-dessus de la deuxième couche ; deux deuxièmes électrodes, formées sur une portion de la deuxième couche qui s'étend au-dessus de la surface du substrat à proximité de l'élément suspendu, connectées à des pistes conductrice latérales respectives dudit guide d'onde, deux canaux du transistor étant délimités par la première et les deuxièmes électrodes ; et deux électrodes de grille de forme allongée, s'étendant sur l'élément suspendu au dessus de canaux respectifs du transistor, séparés de ces derniers par des couche isolantes et connectées à au moins une piste conductrice chevauchant, sans contact électrique, au moins la piste centrale et une piste latérale dudit guide d'onde.

- Le transistor à effet de champ d'un dispositif microélectromécanique selon un troisième mode de réalisation de l'invention comporte : une première électrode, réalisée sur l'élément suspendu, connectée à la piste conductrice centrale dudit guide d'onde; deux deuxièmes électrodes formées sur une portion de la deuxième couche qui s'étend au-dessus de la surface du substrat à proximité de l'élément suspendu, connectée à deux pistes conductrices latérales d'un guide d'onde, un canal du transistor étant délimité par lesdites première et deuxième électrodes. Avantageusement, ce transistor à effet de champ peut comporter également une électrode de grille située entre lesdites première et deuxième électrodes, s'étendant au-dessus du canal du transistor et connectée à une piste conductrice chevauchant, sans contact électrique, au moins la piste centrale dudit guide d'onde.

- Le transistor à effet de champ d'un dispositif microélectromécanique selon un quatrième mode de réalisation de l'invention comporte : une pluralité de premières électrodes réalisées sur l'élément suspendu, alignées dans une direction sensiblement perpendiculaire à celle dudit bord du substrat, et connectées à une piste conductrice centrale d'un guide d'onde s'étendant au-dessus de la deuxième couche ; une pluralité de deuxièmes électrodes réalisées sur l'élément suspendu, alignées dans une direction sensiblement perpendiculaire à celle dudit bord du substrat de manière alternée avec les premières électrodes, et connectées aux pistes conductrices latérales d'un guide d'onde s'étendant au-dessus de la deuxième couche ; et une pluralité d'électrodes de grille situées entre des paires respectives desdites première et deuxième électrodes et connectées à une piste conductrice chevauchant, sans contact électrique, au moins une piste conductrice dudit guide d'onde.

L'élément suspendu d'un dispositif microélectromécanique selon l'invention peut comporter un mode fondamental de vibration de la poutre dans une direction perpendiculaire à la surface dudit substrat dont la fréquence de résonance est comprise entre 10 MHz et 1 GHz, et de préférence entre 1 MHz et 100 MHz. On parle dans ce cas de dispositif opérant à haute fréquence.

Un dispositif microélectromécanique selon l'invention peut être utilisé en tant qu'oscillateur mécanique pour des applications très diverses : réalisation de filtres ou oscillateurs à radiofréquences, capteurs chimiques ou biologiques, capteurs inertiels, sondes de microscopie à force atomique, etc. Dans la plupart de ces applications, il peut être utile de disposer d'un moyen de réglage de la fréquence d'oscillation de l'élément suspendu du dispositif microélectromécanique. Les présents inventeurs ont découvert qu'un tel réglage en fréquence peut être obtenu par l'application d'une première différence de potentiel de valeur appropriée entre aux moins deux électrodes du transistor de détection, dont l'une constitue un drain et l'autre une source. L'application d'une telle différence de potentiel permet en même temps de polariser le transistor pour détecter les oscillations mécaniques par la détection de la composante alternative du courant traversant le canal dudit transistor.

Il est également avantageux d'appliquer une deuxième différence de potentiel entre au moins une électrode de grille et ladite électrode de source dudit transistor, les valeurs desdites première et deuxième différences de potentiel étant déterminées de manière à maximiser le rapport entre le courant drain-source dudit transistor et l'amplitude des vibrations dudit élément suspendu.

En outre, lorsque ledit actionneur est constitué par une première électrode située au-dessus de la deuxième couche et par une deuxième électrode permettant d'appliquer une différence de potentiel à un gaz bidimensionnel de porteurs formé à l'interface entre la première et la deuxième couche, l'application d'une différence de potentiel entre les deux électrodes de l'actionneur permet un réglage d'une amplitude d'une oscillation dudit élément suspendu excitée par ledit actionneur ; les oscillations mécaniques dudit élément suspendu sont ensuite détectées par mesure d'un courant électrique traversant un canal dudit transistor.

Le réglage en fréquence et en amplitude des oscillations ne dépendent pas directement de l'utilisation d'une structure d'interconnexion tridimensionnelle.

D'autres caractéristiques, détails et avantages de l'invention ressortiront à la lecture de la description faite en référence aux dessins annexés donnés à titre d'exemple et qui représentent, respectivement :

- Les figures 1A et 1B, respectivement une vue en coupe et une vue en plan d'un dispositif microélectromécanique d'un type connu de l'art antérieur ;
- La figure 2, une vue en coupe d'un dispositif microélectromécanique selon le principe de l'invention ;
- Les figures 3A, 3B et 3C, respectivement, une vue en plan et deux vues en coupe d'un dispositif microélectromécanique selon un premier mode de réalisation de l'invention ;
- La figure 4, une vue en plan d'un dispositif microélectromécanique selon un deuxième mode de réalisation de l'invention ;
- Les figures 5A, 5B et 5C, respectivement, une vue en plan et deux vues en coupe d'un dispositif microélectromécanique selon un troisième mode de réalisation de l'invention ;
- La figure 6, une vue en plan d'un dispositif microélectromécanique selon un quatrième mode de réalisation de l'invention ;
- La figure 7, une vue en coupe d'un dispositif microélectromécanique selon un cinquième mode de réalisation de l'invention ;
- La figure 8, une vue en coupe correspondant à celle de la figure 3B, mettant en évidence les capacités parasites introduites par la structure d'interconnexion de l'invention ;
- Les figures 9A, 9B, 9C et 9D, des graphiques montrant les courbes de résonance du transistor de détection d'un dispositif microélectromécanique selon l'invention pour différents points de fonctionnement ;
- La figure 10, un graphique illustrant l'accordabilité en amplitude de vibration d'un dispositif microélectromécanique selon l'invention ; et
- Les figures 11A et 11B, un graphique illustrant l'accordabilité en fréquence de vibration d'un dispositif microélectromécanique selon l'invention.

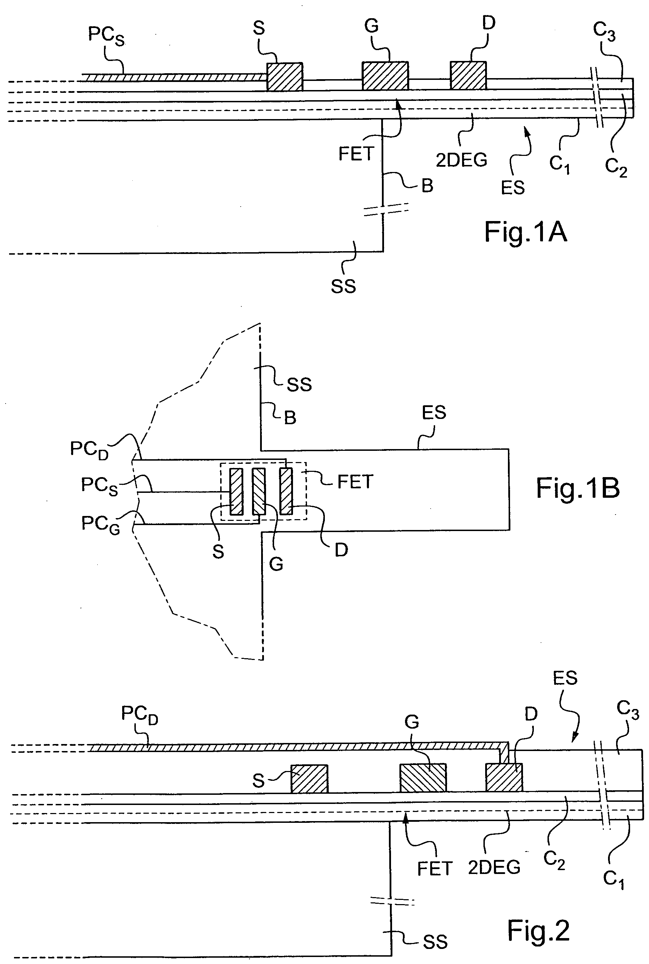

La figure 1A montre une vue en coupe d'un dispositif micromécanique connu de l'art antérieur, basé sur l'utilisation de matériaux semi-conducteurs piézoélectriques de type III-N, et plus précisément de AlGaN et de GaN.

Le dispositif est fabriqué à partir d'un substrat SS, qui peut être réalisé en Si, SiC, verre, ou tout autre matériau adapté, sur lequel sont déposées deux couches épitaxiales $C_1$ et $C_2$, respectivement en GaN et en AlGaN (plus précisément, en $Al_xGaN_{1-x}$ avec $0<x<1$, par exemple en $Al_{0,25}GaN_{0,75}$), ainsi qu'une troisième couche diélectrique $C_3$, typiquement en $SiO_2$, ayant une fonction de passivation.

Des prolongements des couches $C_1$ - $C_3$ s'étendent au-delà d'un bord B du substrat SS pour former un élément suspendu ES, en l'espèce un levier encastré à une extrémité. Typiquement, le bord B n'est pas le bord latéral du substrat, mais le bord d'une cavité réalisé par gravure anisotrope après le dépôt des couches $C_1$ - $C_3$ afin de libérer l'élément suspendu ES.

Les couches $C_1$ et $C_3$ présentent typiquement une épaisseur de quelques centaines de nanomètres (100 - 500 nm, à titre indicatif), tandis que la couche $C_2$ est sensiblement plus mince (10 - 100 nm environ). Les dimensions de l'élément suspendu dépendent des caractéristiques mécaniques souhaitées : typiquement, mais d'une manière non limitative, un micro-levier peut avoir une longueur comprise entre 10 et 1000 $\mu$m et une largeur comprise entre 100 nm et 100 $\mu$m. On remarquera que les figures ne sont pas à l'échelle.

Les matériaux constituant les couches $C_1$ et $C_2$ sont des semi-conducteurs présentant des bandes interdites de largeurs différentes : ils forment ainsi une hétérostructure. Plus précisément, il est connu qu'un gaz bidimensionnel d'électrons (indiqué par la référence 2DEG pour « 2-dimensional electron gaz » en anglais) ou, dans certains cas, de trous, se forme dans la couche $C_1$, quelques nanomètres au-dessous de l'interface. Un tel gaz bidimensionnel de porteurs peut être exploité pour réaliser un transistor à effet de champ de type HEMT qui constitue un excellent capteur de contraintes mécaniques, la conductivité du gaz de porteur étant fortement dépendante de ces contraintes. Pour maximiser la transduction, le canal du transistor doit être réalisé à proximité du bord B, voire à cheval de ce dernier, car c'est là que les contraintes engendrées par les oscillations de l'élément suspendu ES sont les plus importantes.

Comme le montrent les figures 1A et 1B, un tel transistor - identifié par la référence FET, comporte des électrodes, et plus précisément :

- une électrode de drain D, formant un contact ohmique avec les couches $C_1$ et $C_2$, ainsi qu'avec le gaz bidimensionnel de porteurs 2DEG contenu dans la couche $C_1$ ;
- une électrode de source S, qui forme également un contact ohmique avec les couches $C_1$ et $C_2$ ; et
- une électrode de grille G, formant un contact Schottky (destiné à être polarisé inversement) avec la couche $C_2$. En variante, l'électrode de grille G pourrait être séparée des la couche $C_2$ par une couche mince de diélectrique (structure MOS).

Les électrodes D, S et G du transistor FET sont connectées, par l'intermédiaire de vias, à des pistes conductrices $PC_D$, $PC_S$ et $PC_G$ respectivement, déposées au-dessus de la couche de passivation $C_3$.

Dans l'exemple de la figure 1B, le canal du transistor FET est orienté parallèlement à l'axe longitudinal de la poutre ES, tandis que les électrodes S, G et D présentent une forme allongée et sont orientés perpendiculairement audit axe. Il est également possible d'orienter le canal du transistor perpendiculairement à l'axe longitudinal de la poutre et les électrodes parallèlement à cet axe, mais une telle configuration conduit à un facteur de jauge plus faible.

Les présents inventeurs se sont rendu compte du fait que la géométrie d'interconnexion de la figure 1B n'est pas entièrement satisfaisante. En effet :

- Les pistes conductrices passent sur les côtés de l'élément suspendu. Il s'ensuit que le canal du transistor FET ne peut pas occuper toute la largeur dudit élément suspendu, ce qui conduit à une réduction de la jauge de contrainte et à une augmentation de son impédance. Or, pour faciliter l'interfaçage du dispositif, il serait avantageux de disposer d'un transistor dont le canal présente une faible impédance, aussi proche que possible de 50Ω. Ce problème est particulièrement aigu dans le cas des MEMS à « haute fréquence », dont les dimensions sont très réduites.
- La structure d'interconnexion n'est pas symétrique par rapport à l'axe médian de la poutre, ce qui est susceptible de perturber les modes de vibration de cette dernière.
- Les propriétés électriques de la structure d'interconnexion ne sont pas satisfaisantes à haute fréquence.

L'invention vise à résoudre, en totalité ou en partie, les problèmes précités posés par l'art antérieur.

La solution apportée par l'invention consiste à utiliser une structure d'interconnexion tridimensionnelle, dans laquelle au moins deux pistes conductrices connectées à deux électrodes respectives du transistor de détection se chevauchent, sans contact électrique entre elles. La figure 2 montre une vue en coupe d'une telle structure d'interconnexion tridimensionnelle.

L'utilisation de la troisième dimension spatiale permet de s'affranchir des contraintes géométriques liées à la présence de l'élément suspendu ES, et rend donc possible une optimisation des propriétés électriques du transistor. En outre, une telle structure d'interconnexion tridimensionnelle permet de connecter l'électrode de drain et celle de source à des pistes électriques formant un guide d'onde coplanaire, comme cela sera expliqué plus clairement dans la suite, ce qui s'avère être très avantageux dans les applications à haute fréquence. En général, il n'est pas nécessaire d'utiliser une interconnexion à guide d'onde pour l'électrode de grille, qui est utilisée pour fixer le point de fonctionnement du dispositif et dont la piste conductrice d'interconnexion ne transporte donc que des signaux quasi-stationnaires.

En outre, toujours grâce à l'utilisation de la troisième dimension spatiale, il est possible de réaliser des structures d'interconnexion préservant la symétrie de l'élément suspendu ES.

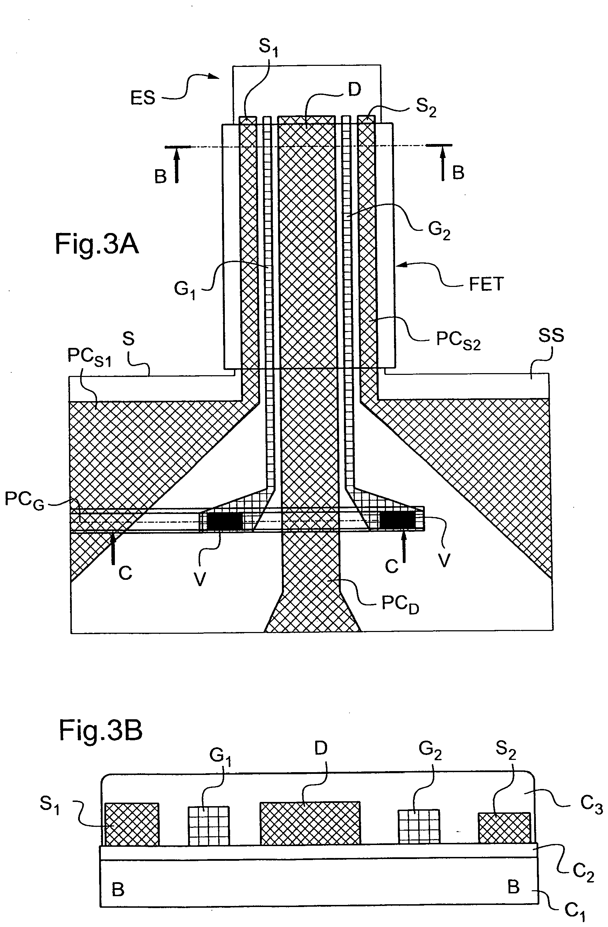

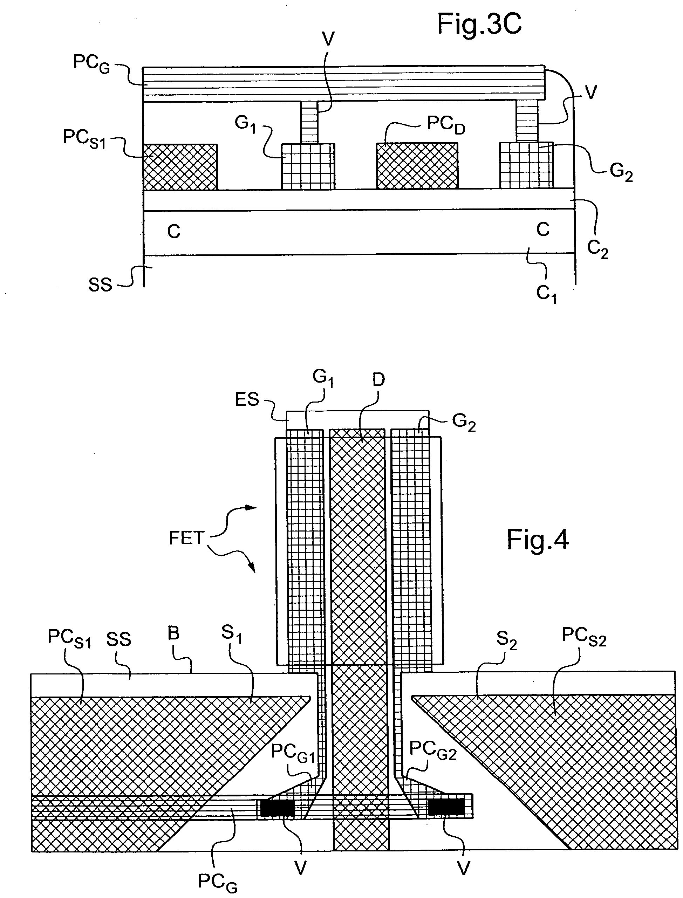

La figure 3A montre une vue en plan d'un dispositif selon un premier mode de réalisation de l'invention ; les figures 3B et 3C montrent des vues en coupe, selon les lignes B-B et C-C respectivement, de ce même dispositif.

Le transistor FET (représenté en gris foncé) de ce dispositif comporte une structure symétrique avec une électrode de drain D centrale, deux électrodes de source $S_1$ et $S_2$ disposées de part et d'autre de ce drain, définissant donc deux canaux de transistor, et deux électrodes de grille $G_1$ et $G_2$ au-dessus de ces canaux. Toutes les électrodes sont orientées selon une direction parallèle à l'axe longitudinal de la poutre ES, c'est à dire perpendiculaire au bord B du substrat.

Les électrodes de drain et de source se prolongent par des pistes conductrices D, $P_{S1}$, $P_{S2}$ qui forment, au dessus du substrat SS, un guide d'onde coplanaire (non représenté sur la figure). Ces pistes conductrices sont déposées directement au-dessus de la deuxième couche conductrice.

Les électrodes de grille $G_1$, $G_2$ sont reliées, par l'intermédiaire de vias ou puits V, à une piste conductrice $PC_G$ déposée au-dessus de la couche de passivation $C_3$ et chevauchant les pistes D et $P_{S1}$ - ce qui donne à la structure d'interconnexion son caractère tridimensionnel.

La figure 4 montre une vue en plan d'un deuxième mode de réalisation de l'invention, qui se présente comme une variante du premier mode qui vient d'être décrit. Dans ce mode de réalisation, les électrodes de source $S_1$, $S_2$ sont réalisées sur une portion de la deuxième couche qui s'étend au-dessus de la surface du substrat à proximité de l'élément suspendu, et seul l'électrode de drain est réalisée sur ce dernier. Les électrodes de grille présentent une surface plus importante que dans le cas des figures 3A - 3C.

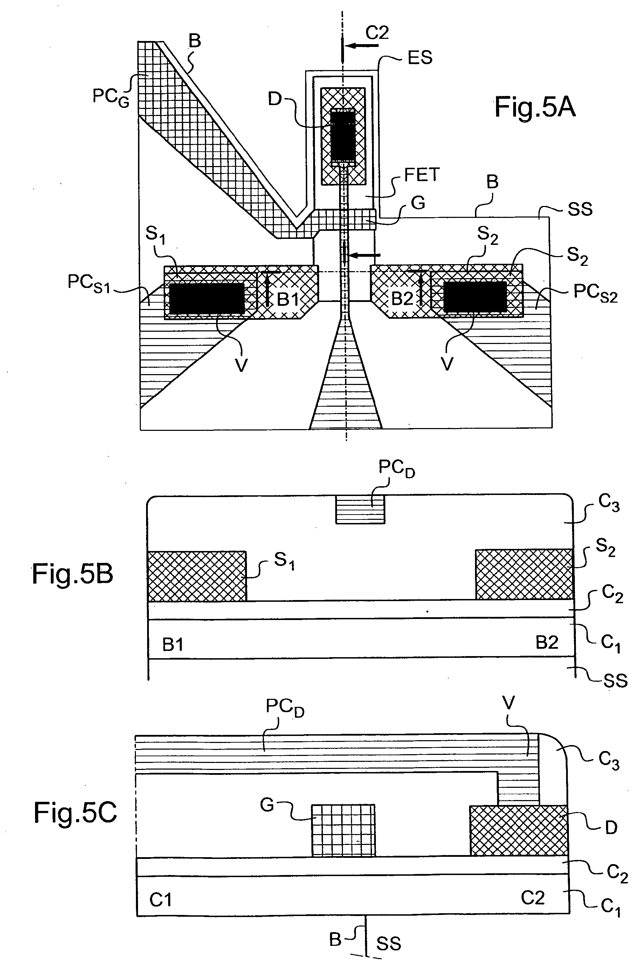

La figure 5A montre une vue en plan d'un dispositif selon un troisième mode de réalisation de l'invention ; les figures 5B et 5C montrent des vues en coupe, selon les lignes B1-B2 et C1-C2 respectivement, de ce même dispositif.

Dans ce mode de réalisation de l'invention, la direction drain - source est parallèle à l'axe longitudinal de la poutre ce qui, comme expliqué plus haut, est optimal en termes de facteur de jauge. Grâce à la structure d'interconnexion de l'invention, la largeur du canal est sensiblement égale à celle de la poutre ES, ce qui permet de minimiser sa résistance.

L'électrode de drain D est réalisée sur la poutre. Elle est connectée, par l'intermédiaire d'un via V, à une piste conductrice $PC_D$ déposée au-dessus de la couche de passivation $C_3$ et chevauchant l'électrode de grille G. Cette piste conductrice $PC_D$ constitue le conducteur central d'un guide d'onde coplanaire, dont les conducteurs latéraux, $PC_{S1}$ et $PC_{S2}$ sont connectés à deux électrodes de source respectifs $S_1$ et $S_2$, réalisés à proximité du point d'encastrement de la poutre (c'est à dire du bord B du substrat).

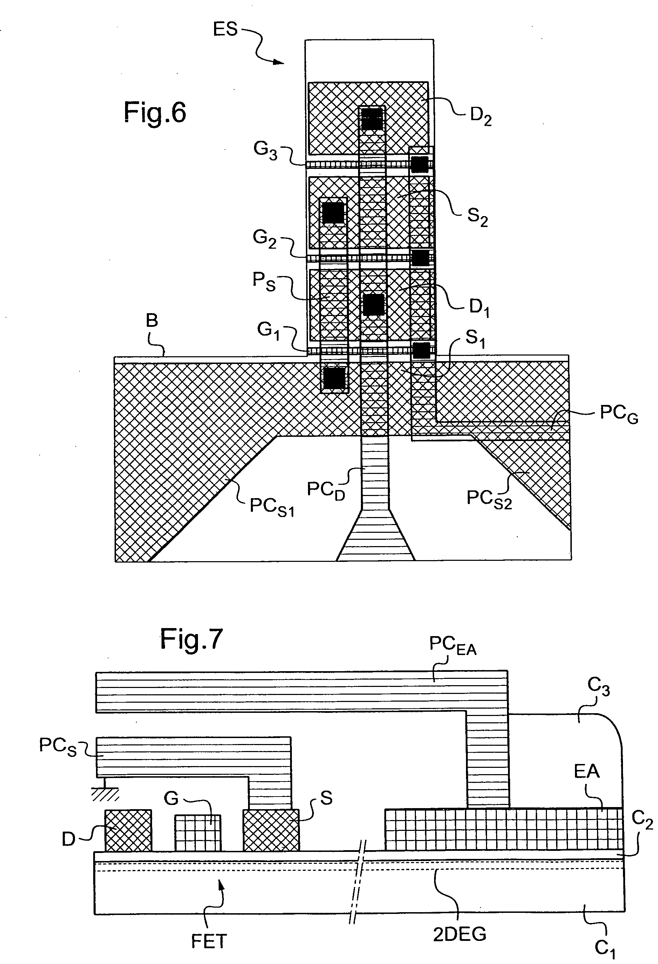

On peut remarquer sur la figure 5A que le bord B du substrat SS n'est pas rectiligne, mais forme un angle obtus au niveau de l'élément suspendu ES. Cela permet de ménager la place pour une piste conductrice de grille $PC_G$ orientée en biais par rapport aux autres pistes conductrices. En variante, ladite piste conductrice de grille $PC_G$ pourrait être déposée au-dessus de la couche de passivation $C_3$ et chevaucher la piste conductrice de source $PC_{s1}$, comme dans le mode de réalisation de la figure 6.

Le mode de réalisation de la figure 6 se caractérise par l'utilisation d'électrodes de drain et de source (et donc de canaux de transistor) multiples, ce qui permet d'augmenter l'intensité du signal de détection des contraintes mécaniques. Les différentes électrodes de source sont connectées entre elles par un « pont » $P_S$ constitué par une piste conductrice déposée au-dessus de la couche de passivation $C_3$, c'est à dire au même niveau que les pistes conductrices de drain et de grille.

Jusqu'ici on a toujours considéré le cas d'un dispositif microélectromécanique dont le seul élément mécanique est une poutre encastrée à l'une de ses extrémités, et libre à l'autre extrémité, et dont le seul élément électrique ou électronique est un transistor de détection. De tels dispositifs peuvent être utilisés, par exemple, en tant qu'accéléromètres, mais il s'agit là d'une application qui est généralement à « basse fréquence », alors que la mise en oeuvre de l'invention s'avère avantageuse surtout à haute fréquence.

L'invention s'applique également à des dispositifs microélectromécaniques différents, et en particulier à des dispositifs de type résonant à poutre doublement encastrée. Ces dispositifs comportent un élément micromécanique suspendu en forme de poutre, reliée au substrat à ses deux extrémités. L'une desdites extrémités porte un capteur, tel qu'un transistor de détection, et l'autre un actionneur qui permet d'exciter un mode de vibration de la poutre à sa fréquence de résonance.

L'actionneur peut exploiter les propriétés piézoélectriques de la deuxième couche épitaxiale $C_2$, en AlGaN, et être constitué par deux électrodes en contact électrique avec deux faces opposées de cette couche. Plus précisément, une électrode supérieure peut être constituée par une métallisation réalisée au-dessus de la couche $C_2$ avant le dépôt de la couche de passivation $C_3$ (voir la référence EA sur la figure 7); et une électrode inférieure peut être constituée par le gaz bidimensionnel de porteurs 2DEG, dont le potentiel est fixé par un contact électrique réalisé par l'intermédiaire d'un via ou d'un contact ohmique traversant ladite deuxième couche.

D'une manière connue en soi, un MEMS résonant de ce type peut servir comme oscillateur électromécanique pour générer une base de temps, comme filtre dans des applications radio-électroniques, ou comme sonde pour microscopie à force atomique. Il peut également être utilisé comme capteur chimique ou biologique ; pour ce faire, il est nécessaire de fonctionnaliser une surface du levier, de manière à ce que des analytes puissent s'y fixer et modifier sa masse, et donc sa fréquence de résonance.

La figure 7 montre une vue en coupe d'un dispositif de ce type, dans lequel l'électrode supérieur EA de l'actionneur piézoélectrique est connecté à une piste $PC_{EA}$ qui forme un troisième niveau de métallisation et passe au-dessus du transistor de détection FET et de la piste conductrice de source $PC_S$. Une telle structure présente l'avantage de permettre d'accéder à l'actionneur et au capteur par un même côté du dispositif.

Avantageusement, la piste conductrice de source $PC_S$ est reliée à la masse, ce qui permet d'éviter tout couplage capacitif direct entre l'actionneur et le détecteur.

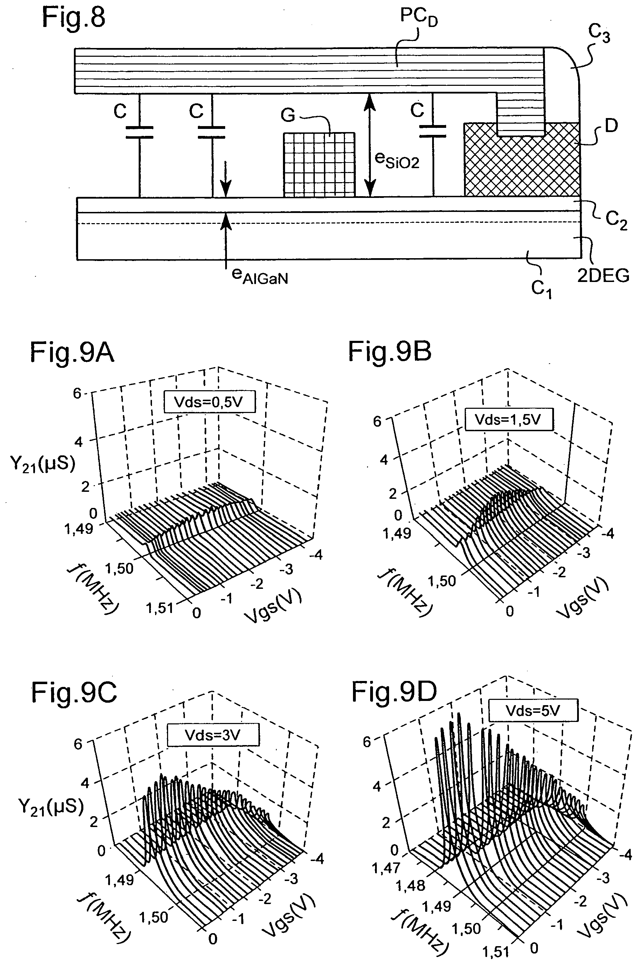

L'existence de couplages capacitifs parasites est justement la raison pour laquelle l'utilisation d'une structure d'interconnexion selon l'invention semblerait, de prime abord, à proscrire. Cet effet sera étudié plus en détail ci-après, à l'aide de la figure 8 qui se rapporte à la structure des figures 5A - C.

La figure 8 montre qu'il existe une capacité distribué C entre la piste conductrice de drain $PC_D$ et le plan conducteur formé par le gaz bidimensionnel de porteurs 2DEG à l'intérieur du canal du transistor, supposé localisé à l'interface $C_1$-$C_2$, même si en réalité il se trouve à quelques dizaines de nanomètres (typiquement 20 - 50 nm) de cette interface.

La valeur de la capacité C est donnée par :

$$C = \frac{\varepsilon_0 S}{\dfrac{e_{SiO2}}{\varepsilon_{SiO2}} + \dfrac{e_{AlGaN}}{\varepsilon_{AlGaN}}}$$

où :

- $e_{SiO2}$ est l'épaisseur de la couche de passivation $C_3$, supposée égale à 100 nm ;
- $\varepsilon_{SiO2}$ est la constante diélectrique relative du $SiO_2$ constituant ladite couche de passivation $C_3$, égale à 3,9 environ ;
- $e_{AlGaN}$ est l'épaisseur de la deuxième couche $C_2$, supposée égale à 20 nm ;
- $\varepsilon_{SiO2}$ est la constante diélectrique relative du AlGaN constituant ladite deuxième couche $C_2$, égale à 9,5 environ ;
- $\varepsilon_0$ est la constante diélectrique du vide, égale à $8{,}85 \cdot 10^{-12}$ F/m ;
- S est la surface de la partie de la piste conductrice PCD qui se trouve directement au-dessus du canal du transistor et qui contribue de ce fait à la capacité (on néglige les effets de bord) ; on considère une piste de 1 μm de largeur et de 9 μm de longueur, ce qui donne S=9 μm².

Avec ces valeurs, $C = 3\,fF = 3 \cdot 10^{-15}$ F.

Le canal du transistor présente une largeur de 4 μm, et on peut estimer sa résistance $R_c$ à 1 kΩ.

Dans ces conditions, le comportement résistif de la structure est dominant, par rapport au comportement capacitif, jusqu'à une fréquence $f=1/(2\pi R_c C) \cong 50$ GHz. Les effets capacitifs peuvent donc être négligés jusqu'à des fréquences de l'ordre de 1 GHz, bien supérieures à celles usuellement mises en oeuvre dans le domaine des dispositifs microélectromécaniques résonants.

Pour le mode de réalisation de la figure 6, on obtient des résultats comparables. Dans ce cas, la surface S à prendre en compte est celle des portions des pistes conductrices $PC_D$, $PC_S$ et du « pont » $P_S$ qui se superposent aux électrodes D, S, G et à la piste conductrice « enterrée » $PC_S$.

Dans le cas de la figure 4, la capacité parasite est plus faible d'un facteur 2 environ, ce qui donne $f \cong 100$ GHz.

Après avoir décrit plusieurs structures d'interconnexion selon l'invention, on peut considérer plus en détail le fonctionnement du transistor de détection FET.

On considère un MEMS comportant un élément suspendu en forme de poutre constitué par une première couche $C_1$ et une deuxième couche $C_2$ piézoélectriques (plus, éventuellement, une troisième couche de passivation qui sera ignorée par la suite). Un mode de vibration de la poutre dans une direction perpendiculaire à la surface du substrat et des couches $C_1$ et $C_2$, à une fréquence f, est excité. Soit x la direction de l'axe longitudinal de la poutre, y la direction transversale et z la direction de vibration.

Les deux couches piézoélectriques sont soumises, du fait de la vibration de la poutre, à une même déformation mécanique $\varepsilon(f)$, mais la différence entre leurs propriétés piézoélectrique engendre une variation $\Delta\sigma$ de la charge de surface présente à leur interface (si les matériaux sont semi-conducteurs, une charge de surface à l'interface est présente même en l'absence de déformation mécanique) :

$$\Delta\sigma = \left[\left(\varepsilon_x(f) + \varepsilon_y(f)\right)\right] \cdot \left[e_{31AlGaN} - e_{31GaN}\right] + \varepsilon_z(f) \cdot \left[e_{33AlGaN} - e_{33GaN}\right]$$

où :

$\varepsilon_i(f)$ est la composante le long de la direction i (i=x, y, z) de la déformation mécanique ;
$e_{ijGaN}$ est la composante ij (i,j= 1 - 3) du tenseur piézoélectrique de la première couche (supposée réalisée en GaN) ; et
$e_{ijAlGaN}$ est la composante ij (i,j= 1 - 3) du tenseur piézoélectrique de la deuxième couche (supposée réalisée en AlGaN).

En outre, une charge de volume $\Delta\rho(f)$ apparaît dans la première couche en GaN, plus épaisse :

$$\Delta\rho(f) = -div\left(\Delta P_{PZ}\right) = e_{31GaN} \cdot \left(\frac{\partial\varepsilon_x(f)}{\partial z} + \frac{\partial\varepsilon_y(f)}{\partial z}\right) - e_{33GaN} \cdot \frac{\partial\varepsilon_z(f)}{\partial z}$$

où $\Delta P_{PZ}$ est la polarisation en volume induite par l'effet piézoélectrique.

Les équations ci-dessus permettent de comprendre qu'il n'est pas essentiel que les deux matériaux constituant les couches $C_1$ et $C_2$ soient à la fois semi-conducteurs et piézoélectriques, bien qu'il s'agisse là d'un mode de réalisation préféré de l'invention. Il suffit que la première couche soit piézoélectrique, et la deuxième semiconductrice (de préférence monocristalline, pour présenter des bonnes propriétés électroniques).

Le tableau ci-après montre des couples de matériaux pouvant convenir à la réalisation des couches $C_1$ et $C_2$ :

| $C_1$ | $C_2$ |
|-------|-------|
| ZnO | Si |

(suite)

| $C_1$ | $C_2$ |
|-------|-------|
| SiC | Si |
| GaN | AlGaN |
| GaAs | AlGaAs |
| ZnO | ZnMgO |
| GaN | ZnO |

Par ailleurs, les deux couches $C_1$ et $C_2$ ne forment pas nécessairement une hétérostructure, et le transistor FET n'est pas nécessairement de type HEMT.

Si la couche piézoélectrique $C_1$ est isolante, le transistor FET sera réalisé entièrement à l'intérieur de la couche semiconductrice (piézoélectrique ou pas) $C_2$. En particulier, cette dernière peut être constituée d'un empilement de sous-couches semi-conductrices, concentrant les porteurs dans la partie inférieure de la couche, éventuellement sous la forme d'un gaz bidimensionnel.

L'utilisation d'une première couche $C_1$ piézoélectrique mais non semi-conductrice (isolante) et d'une deuxième couche $C_2$ semi-conductrice mais non piézoélectrique, ou très faiblement piézoélectrique, peut s'avérer avantageuse dans certains cas. En effet, cela peut permettre une meilleure optimisation des propriétés, respectivement piézoélectrique et électroniques, des matériaux. La première couche pourrait également être optimisée du point de vue de ses propriétés mécaniques et/ou thermiques sans que son choix soit contraint par l'utilisation d'un semiconducteur piézoélectrique.

Les graphiques des figures 9A - 9D permettent d'apprécier l'avantage apporté par l'utilisation d'un transistor de détection par rapport à un simple capteur de contraintes piézoélectrique. Ces graphiques se rapportent au cas d'un MEMS de type résonant, à poutre doublement encastré, comportant un actionneur piézoélectrique à l'une de ses extrémités et un transistor FET de détection à l'extrémité opposée, et montrent la dépendance de la transconductance $Y_{21}$ du dispositif en fonction de la fréquence f et du point de fonctionnement du transistor FET, caractérisé par la tension grille-source ($V_{gs}$) et drain-source (Vds). La transconductance $Y_{21}$ exprime le rapport entre le courant drain-source du transistor FET et la tension alternative, à la fréquence f, appliquée aux bornes de l'actionneur piézoélectrique ; elle exprime donc la réponse électromécanique du dispositif.

Les courbes 9A - 9D permettent de déterminer le point de fonctionnement du transistor FET maximisant le signal de détection, aussi bien dans le cas de vibrations forcées que dans celui des vibrations libres (sans actionneur) de l'élément suspendu.

On peut observer que, dans les conditions optimales de fonctionnement ($V_{ds}$= 5V ; $V_{gs}$ compris entre 0 et -2 V, le signe «-» indiquant que la jonction Schottky de grille est polarisée inversement) la transconductance $Y_{21}$ est de plusieurs $\mu$S. Cette valeur est supérieure de deux ordres de grandeur à celle obtenue en utilisant, pour la détection des vibrations de la poutre, un simple capteur piézoélectrique identique à l'actionneur.

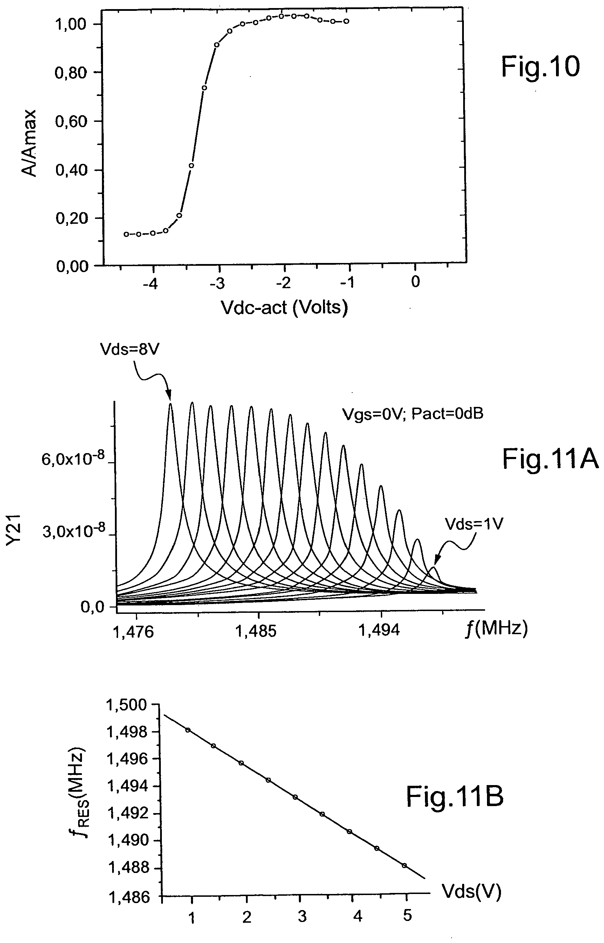

La comparaison des différents graphiques 9A - 9D montre que la fréquence de résonance $f_{res}$ varie en fonction de la tension drain-source $V_{ds}$. Cet effet, mis en évidence sur les figures 11A et 11B, rend possible une accordabilité de ladite fréquence de résonance. Il est important de noter que l'on peut accorder la fréquence tout en conservant la même amplitude du signal, simplement en imposant une valeur de tension drain-source $V_{ds}$ assez haute pour assurer le fonctionnement du transistor en régime de saturation.

La figure 10 montre qu'un réglage d'un facteur 10 environ de l'amplitude normalisée $A/A_{max}$ de l'oscillation de la poutre peut être obtenue en appliquant à l'actionneur piézoélectrique une polarisation stationnaire Vdc-act. Pour obtenir des oscillations de grande amplitude, il est préférable de polariser l'actionneur piézoélectrique avec une tension continue de l'ordre de $V_p/2$, $V_p$ étant la tension de pincement du gaz bidimensionnel de porteurs, et d'appliquer audit actionneur une tension alternative Vac-act, à la fréquence de résonance de la poutre, ayant également une amplitude de l'ordre de Vp/2. Pour diminuer l'amplitude des oscillations, il est possible de diminuer tant Vdc-act que Vac-act.

## Revendications

1. Dispositif microélectromécanique comportant :

- un substrat (SS) ;
- une première couche ($C_1$) d'un matériau piézoélectrique, déposée sur une surface dudit substrat ;
- une deuxième couche ($C_2$) d'un matériau semiconducteur, déposée sur ladite première couche ;

- au moins un élément suspendu (ES), formé par des prolongements desdites couches s'étendant au-delà d'un bord (B) dudit substrat ;
- un transistor à effet de champ (FET) intégré à ladite deuxième couche et à son prolongement, ayant au moins un canal s'étendant au moins en partie à l'intérieur dudit élément suspendu, comportant des électrodes (D, S, G) connectées à des pistes conductrices ($PC_D$, $PC_S$, $PC_G$) s'étendant au-dessus de ladite deuxième couche et dont au moins une passe par-dessus ledit bord du substrat ;

**caractérisé en ce que** :

- au moins deux pistes conductrices connectées à deux électrodes respectives du transistor à effet de champ se chevauchent, sans contact électrique entre elles, de manière à former une structure d'interconnexion tridimensionnelle.

2. Dispositif microélectromécanique selon la revendication 1, dans lequel au moins une électrode de drain et une électrode de source dudit transistor à effet de champ sont connectées à des pistes électriques formant un guide d'onde.

3. Dispositif microélectromécanique selon l'une des revendications précédentes, comportant également une troisième couche ($C_3$), réalisée en un troisième matériau diélectrique, recouvrant au moins partiellement ladite deuxième couche et sur laquelle est déposée au moins une desdites pistes électriques, des vias (V) étant pratiqués dans ladite troisième couche pour permettre l'interconnexion de ladite ou de chaque dite piste électrique avec les électrodes du transistor à effet de champ.

4. Dispositif microélectromécanique selon la revendication 3, dans lequel :

- ledit élément présente une forme choisie entre une poutre encastrée à ses deux extrémités et un disque ou plaque encastré sur tout son périmètre, ledit transistor à effet de champ étant formé au niveau d'une partie d'encastrement dudit élément ;
- le dispositif comporte également un actionneur (EA) réalisé au niveau d'une partie dudit élément suspendu autre que celle portant ledit transistor, ledit actionneur étant adapté pour exciter un mode de vibration de l'élément suspendu dans une direction perpendiculaire à la surface dudit substrat ; et ledit actionneur comporte des électrodes en contact électrique avec deux faces opposées de ladite deuxième couche, qui est réalisée en matériau semi-conducteur piézoélectrique.

5. Dispositif microélectromécanique selon l'une des revendications précédentes, dans lequel ladite première couche est réalisée en un matériau semiconducteur piézoélectrique différent de celui constituant la deuxième couche, de telle manière que l'interface entre la première et la deuxième couche forme une hétérostructure semiconductrice.

6. Dispositif microélectromécanique selon la revendication 5, dans lequel ladite deuxième couche est également réalisée en matériau semiconducteur piézoélectrique, différent de celui constituant la première couche.

7. Dispositif microélectromécanique selon l'une des revendications 5 ou 6, dans lequel un gaz bidimensionnel de porteurs (2DEG) est formé à l'interface entre la première et la deuxième couche.

8. Dispositif microélectromécanique selon la revendication 7, dans lequel la première et la deuxième couches sont réalisées en des matériaux semi-conducteurs piézoélectriques différents, de type III-N ou GaN.

9. Dispositif microélectromécanique selon l'une des revendications précédentes, dans lequel le transistor à effet de champ comporte :

- une première électrode (D) de forme allongée, s'étendant sur l'élément suspendu dans une direction sensiblement perpendiculaire à celle dudit bord du substrat, connectée à une piste conductrice centrale d'un guide d'onde s'étendant au-dessus de la deuxième couche ;
- deux deuxièmes électrodes ($S_1$, $S_2$) de forme allongée, s'étendant sur l'élément suspendu dans une direction sensiblement perpendiculaire à celle dudit bord du substrat, disposées de part et d'autre de la première électrode et connectées à des pistes conductrice latérales respectives dudit guide d'onde, deux canaux du transistor étant délimités par la première et les deuxièmes électrodes ; et
- deux électrodes de grille ($G_1$, $G_2$) de forme allongée, s'étendant sur l'élément suspendu au dessus de canaux respectifs du transistor, séparés de ces derniers par des couche isolantes et connectées à au moins une piste conductrice chevauchant, sans contact électrique, au moins la piste centrale et une piste latérale dudit guide d'onde.

**10.** Dispositif microélectromécanique selon l'une des revendications 1 à 8, dans lequel le transistor à effet de champ comporte :

- une première électrode de forme allongée (D), s'étendant sur l'élément suspendu dans une direction sensiblement perpendiculaire à celle dudit bord du substrat, connectée à une piste conductrice centrale d'un guide d'onde s'étendant au-dessus de la deuxième couche ;
- deux deuxièmes électrodes ($S_1$, $S_2$), formées sur une portion de la deuxième couche qui s'étend au-dessus de la surface du substrat à proximité de l'élément suspendu, connectées à des pistes conductrice latérales respectives dudit guide d'onde, deux canaux du transistor étant délimités par la première et les deuxièmes électrodes ; et
- deux électrodes de grille ($G_1$, $G_2$) de forme allongée, s'étendant sur l'élément suspendu au dessus de canaux respectifs du transistor, séparés de ces derniers par des couche isolantes et connectées à au moins une piste conductrice chevauchant, sans contact électrique, au moins la piste centrale et une piste latérale dudit guide d'onde.

**11.** Dispositif microélectromécanique selon la revendication 2 ou l'une quelconque des revendications 3 à 8 lorsqu'elle dépend de la revendication 2 dans lequel le transistor à effet de champ comporte :

- une première électrode (D), réalisée sur l'élément suspendu, connectée à la piste conductrice centrale dudit guide d'onde; et
- deux deuxièmes électrodes ($S_1$, $S_2$) formées sur une portion de la deuxième couche qui s'étend au-dessus de la surface du substrat à proximité de l'élément suspendu, connectées à deux pistes conductrices latérales d'un guide d'onde, un canal du transistor étant délimité par lesdites première et deuxième électrodes.

**12.** Dispositif microélectromécanique selon la revendication 11, dans lequel le transistor à effet de champ comporte également une électrode de grille (G) située entre lesdites première et deuxième électrodes, s'étendant au-dessus du canal du transistor et connectée à une piste conductrice chevauchant, sans contact électrique, au moins la piste centrale dudit guide d'onde.

**13.** Dispositif microélectromécanique selon l'une des revendications 1 à 8 dans lequel le transistor à effet de champ comporte :

- une pluralité de premières électrodes ($D_1$, $D_2$) réalisées sur l'élément suspendu, alignées dans une direction sensiblement perpendiculaire à celle dudit bord du substrat, et connectées à une piste conductrice centrale d'un guide d'onde s'étendant au-dessus de la deuxième couche ;
- une pluralité de deuxièmes électrodes ($S_1$, $S_2$) réalisées sur l'élément suspendu, alignées dans une direction sensiblement perpendiculaire à celle dudit bord du substrat de manière alternée avec les premières électrodes, et connectées aux pistes conductrices latérales d'un guide d'onde s'étendant au-dessus de la deuxième couche ; et
- une pluralité d'électrodes de grille ($G_1$, $G_2$) situées entre des paires respectives desdites première et deuxième électrodes et connectées à une piste conductrice chevauchant, sans contact électrique, au moins une piste conductrice dudit guide d'onde.

**14.** Dispositif microélectromécanique selon l'une des revendications précédentes, dans lequel ledit élément (ES) suspendu comporte un mode fondamental de vibration de la poutre dans une direction perpendiculaire à la surface dudit substrat dont la fréquence de résonance est comprise entre 10 MHz et 1 GHz, et de préférence entre 1 MHz et 100 MHz.

**15.** Procédé d'utilisation d'un dispositif microélectromécanique selon l'une des revendications précédentes en tant qu'oscillateur mécanique, comportant :

- l'application d'une première différence de potentiel ($V_{ds}$) entre aux moins deux électrodes dudit transistor, dont l'une constitue un drain et l'autre une source, la valeur de ladite différence de potentiel étant choisie de manière à permettre un réglage d'une fréquence de résonance dudit oscillateur ; et

- la détection d'oscillations mécaniques dudit élément suspendu par mesure d'un courant électrique traversant un canal dudit transistor.

**16.** Procédé selon la revendication 15 comportant également l'application d'une deuxième différence de potentiel ($V_{gs}$) entre au moins une électrode de grille et ladite électrode de source dudit transistor, les valeurs desdites première et deuxième différences de potentiel étant déterminées de manière à maximiser le rapport entre le courant drain-source dudit transistor et l'amplitude des vibrations dudit élément suspendu.

**17.** Procédé d'utilisation d'un dispositif microélectromécanique selon la revendication 4, dans lequel ledit actionneur est constitué par une première électrode située au-dessus de la deuxième couche et par une deuxième électrode permettant d'appliquer une différence de potentiel à un gaz bidimensionnel de porteurs formé à l'interface entre la première et la deuxième couche, comportant :

- l'application d'une différence de potentiel (Vdc-act) entre les deux électrodes de l'actionneur de manière à permettre un réglage d'une amplitude d'une oscillation dudit élément suspendu excitée par ledit actionneur ; et
- la détection d'oscillations mécaniques dudit élément suspendu par mesure d'un courant électrique traversant un canal dudit transistor.

**Patentansprüche**

**1.** Mikroelektromechanische Anordnung, die Folgendes umfasst:

- ein Substrat (SS);
- eine erste Schicht ($C_1$) aus einem piezoelektrischen Material, das auf einer Fläche des Substrats abgeschieden ist;
- eine zweite Schicht ($C_2$) aus einem halbleitenden Material, das auf der ersten Schicht abgeschieden ist;
- mindestens ein aufgehängtes Element (ES), das durch Verlängerungen der Schichten gebildet ist, die sich über einen Rand (B) des Substrats hinaus erstrecken;
- einen Feldeffekttransistor (FET), der in die zweite Schicht und in ihre Verlängerung integriert ist, der mindestens einen Kanal aufweist, der sich zumindest teilweise im Inneren des aufgehängten Elements erstreckt, Elektroden (D, S, G) umfasst, die mit Leiterbahnen ($PC_D$, $PC_S$, $PC_G$) verbunden sind, die sich über der zweiten Schicht erstrecken und von denen mindestens eine über den Rand des Substrats verläuft;

**dadurch gekennzeichnet, dass**:

- mindestens zwei Leiterbahnen, die mit zwei entsprechenden Elektroden des Feldeffekttransistors verbunden sind, sich derart ohne elektrischen Kontakt zueinander überlappen, dass sie eine dreidimensionale Zusammenschaltungsstruktur bilden.

**2.** Mikroelektromechanische Anordnung nach Anspruch 1, wobei mindestens eine Drain-Elektrode und eine Source-Elektrode des Feldeffekttransistors mit elektrischen Bahnen verbunden sind, die einen Wellenleiter bilden.

**3.** Mikroelektromechanische Anordnung nach einem der vorhergehenden Ansprüche, die auch eine dritte Schicht ($C_3$) umfasst, die aus einem dritten dielektrischen Material hergestellt ist, die zweite Schicht zumindest teilweise bedeckt und auf der mindestens eine der elektrischen Bahnen abgeschieden ist, wobei Durchkontaktierungen (V) in der dritten Schicht hergestellt sind, um die Zusammenschaltung der oder jeder elektrischen Bahn mit den Elektroden des Feldeffekttransistors zu ermöglichen.

**4.** Mikroelektromechanische Anordnung nach Anspruch 3, wobei:

- das Element eine Form aufweist, die zwischen einem Balken, der an seinen zwei Enden eingelassen ist, und einer Scheibe oder Platte ausgewählt ist, die über ihren gesamten Umfang eingelassen ist, wobei der Feldeffekttransistor im Bereich eines Einlassungsteils des Elements gebildet ist;
- die Anordnung auch ein Stellglied (EA) umfasst, das im Bereich eines Teils des aufgehängten Elements hergestellt ist, das sich von demjenigen unterscheidet, das den Transistor trägt, wobei das Stellglied angepasst ist, um eine Schwingungsform des aufgehängten Elements in eine Richtung senkrecht zur Fläche des Substrats zu erregen; und das Stellglied Elektroden umfasst, die in elektrischem Kontakt mit zwei entgegengesetzten Seiten der zweiten Schicht sind, die aus einem piezoelektrischen halbleitenden Material hergestellt ist.

5. Mikroelektromechanische Anordnung nach einem der vorhergehenden Ansprüche, wobei die erste Schicht aus einem piezoelektrischen halbleitenden Material hergestellt ist, das sich von demjenigen unterscheidet, das die zweite Schicht bildet, derart, dass die Grenzfläche zwischen der ersten und der zweiten Schicht eine halbleitende Heterostruktur bildet.

6. Mikroelektromechanische Anordnung nach Anspruch 5, wobei die zweite Schicht auch aus piezoelektrischem halbleitenden Material hergestellt ist, das sich von demjenigen unterscheidet, das die erste Schicht bildet.

7. Mikroelektromechanische Anordnung nach einem der Ansprüche 5 oder 6, wobei ein zweidimensionales Ladungsträgergas (2DEG) an der Grenzfläche zwischen der ersten und der zweiten Schicht gebildet ist.

8. Mikroelektromechanische Anordnung nach Anspruch 7, wobei die erste und die zweite Schicht aus unterschiedlichen piezoelektrischen Halbleitermaterialien vom Typ III-N oder GaN gebildet sind.

9. Mikroelektromechanische Anordnung nach einem der vorhergehenden Ansprüche, wobei der Feldeffekttransistor Folgendes umfasst:

- eine erste Elektrode (D) mit länglicher Form, die sich auf dem aufgehängten Element in eine Richtung erstreckt, die im Wesentlichen senkrecht zu derjenigen des Randes des Substrats ist, mit einer mittleren Leiterbahn eines Wellenleiters verbunden ist, die sich über der zweiten Schicht erstreckt;
- zwei zweite Elektroden (S$_1$, S$_2$) mit länglicher Form, die sich auf dem aufgehängten Element in eine Richtung erstrecken, die im Wesentlichen senkrecht zu derjenigen des Randes des Substrats ist, die auf beiden Seiten der ersten Elektrode angeordnet sind und mit jeweiligen seitlichen Leiterbahnen des Wellenleiters verbunden sind, wobei zwei Kanäle des Transistors durch die erste und die zweite Elektrode abgegrenzt sind; und
- zwei Gate-Elektroden (G$_1$, G$_2$) mit länglicher Form, die sich auf dem aufgehängten Element über entsprechenden Kanälen des Transistors erstrecken, die durch diese letzteren durch isolierende Schichten getrennt sind und mit mindestens einer Leiterbahn verbunden sind, die sich ohne elektrischen Kontakt mit mindestens der mittleren Bahn und einer seitlichen Bahn des Wellenleiters überlappt.

10. Mikroelektromechanische Anordnung nach einem der Ansprüche 1 bis 8, wobei der Feldeffekttransistor Folgendes umfasst:

- eine erste Elektrode mit länglicher Form (D), die sich auf dem aufgehängten Element in einer Richtung erstreckt, die im Wesentlichen senkrecht zu derjenigen des Randes des Substrats ist, mit einer mittleren leitfähigen Bahn eines Wellenleiters verbunden ist, die sich über der zweiten Schicht erstreckt;
- zwei zweite Elektroden (S$_1$, S$_2$), die auf einem Abschnitt der zweiten Schicht gebildet sind, der sich über der Fläche des Substrats in der Nähe des aufgehängten Elements erstreckt, mit zwei jeweiligen seitlichen Leiterbahnen des Wellenleiters verbunden sind, wobei zwei Kanäle des Transistors durch die erste und die zweite Elektrode abgegrenzt sind; und
- zwei Gate-Elektroden (G$_1$, G$_2$) mit länglicher Form, die sich auf dem aufgehängten Element über jeweiligen Kanälen des Transistors erstrecken, von diesen letzteren durch isolierende Schichten getrennt sind und mit mindestens einer Leiterbahn verbunden sind, die ohne elektrischen Kontakt mindestens die mittlere Bahn und eine seitliche Bahn des Wellenleiters überlappt.

11. Mikroelektromechanische Anordnung nach Anspruch 2 oder einem der Ansprüche 3 bis 8, sofern diese/r von Anspruch 2 abhängig ist/sind, wobei der Feldeffekttransistor Folgendes umfasst:

- eine erste Elektrode (D), die auf dem aufgehängten Element hergestellt ist, mit der mittleren Leiterbahn des Wellenleiters verbunden ist; und
- zwei zweite Elektroden (S$_1$, S$_2$), die auf einem Abschnitt der zweiten Schicht gebildet sind, der sich über der Fläche des Substrats in der Nähe des aufgehängten Elements erstreckt, mit zwei seitlichen Leiterbahnen eines Wellenleiters verbunden sind, wobei ein Kanal des Transistors durch die erste und die zweite Elektrode abgegrenzt ist.

12. Mikroelektromechanische Anordnung nach Anspruch 11, wobei der Feldeffekttransistor auch eine Gate-Elektrode (G) umfasst, die sich zwischen der ersten und der zweiten Elektrode befindet, die sich über dem Kanal des Transistors erstreckt und mit einer Leiterbahn verbunden ist, die ohne elektrischen Kontakt mindestens die mittlere Bahn des Wellenleiters überlappt.

**13.** Mikroelektromechanische Anordnung nach einem der Ansprüche 1 bis 8, wobei der Feldeffekttransistor Folgendes umfasst:

- mehrere erste Elektroden ($D_1$, $D_2$), die auf dem aufgehängten Element hergestellt sind, in einer Richtung ausgerichtet sind, die im Wesentlichen senkrecht zu derjenigen des Randes des Substrats ist, und mit einer mittleren Leiterbahn eines Wellenleiters verbunden sind, der sich über der zweiten Schicht erstreckt;
- mehrere zweite Elektroden ($S_1$, $S_2$), die auf dem aufgehängten Element in eine Richtung im Wesentlichen senkrecht zu derjenigen des Randes des Substrats ausgerichtet auf mit den ersten Elektroden abwechselnde Art und Weise hergestellt sind und mit den seitlichen Leiterbahnen eines Wellenleiters verbunden sind, der sich über der zweiten Schicht erstreckt; und
- mehrere Gate-Elektroden ($G_1$, $G_2$), die sich zwischen entsprechenden Paaren von der ersten und der zweiten Elektrode befinden und mit einer Leiterbahn verbunden sind, die mindestens eine Leiterbahn des Wellenleiters ohne elektrischen Kontakt überlappt.

**14.** Mikroelektromechanische Anordnung nach einem der vorhergehenden Ansprüche, wobei das aufgehängte Element (ES) eine Grundschwingungsform des Balkens in eine Richtung senkrecht zur Fläche des Substrats umfasst, deren Resonanzfrequenz zwischen 10 MHz und 1 GHz, und vorzugsweise zwischen 1 MHz und 100 MHz enthalten ist.

**15.** Verfahren zur Verwendung einer mikroelektromechanischen Anordnung nach einem der vorhergehenden Ansprüche als mechanischer Oszillator, das Folgendes umfasst:

- das Anlegen einer ersten Potenzialdifferenz ($V_{ds}$) zwischen mindestens zwei Elektroden des Transistors, von denen eine einen Drain und die andere eine Source bildet, wobei der Wert der Potenzialdifferenz derart ausgewählt wird, dass eine Regelung der Resonanzfrequenz des Oszillators ermöglicht wird; und
- die Detektion mechanischer Oszillationen des aufgehängten Elements durch Messung eines elektrischen Stroms, der durch einen Kanal des Transistors fließt.

**16.** Verfahren nach Anspruch 15, das auch die Anwendung einer zweiten Potenzialdifferenz ($V_{gs}$) zwischen mindestens einer Gate-Elektrode und der Source-Elektrode des Transistors umfasst, wobei die Werte der ersten und zweiten Potenzialdifferenz derart bestimmt werden, dass das Verhältnis zwischen dem Drain-Source-Strom des Transistors und der Amplitude der Schwingungen des aufgehängten Elements maximiert wird.

**17.** Verfahren zur Verwendung einer mikroelektromechanischen Anordnung nach Anspruch 4, wobei das Stellglied aus einer ersten Elektrode, die sich über der zweiten Schicht befindet, und aus einer zweiten Elektrode besteht, die das Anlegen einer Potenzialdifferenz an ein zweidimensionales Ladungsträgergas ermöglicht, das an der Grenzfläche zwischen der ersten Schicht und der zweiten Schicht gebildet ist, das Folgendes umfasst:

- das Anlegen einer Potenzialdifferenz (Vdc-act) zwischen den zwei Elektroden des Stellglieds, derart, dass eine Regelung einer Amplitude einer Schwingung des aufgehängten Elements, die durch das Stellglied erregt wird, ermöglicht wird; und
- die Detektion von mechanischen Schwingungen des aufgehängten Elements durch Messung eines elektrischen Stroms, der durch einen Kanal des Transistors fließt.

## Claims

**1.** A micro-electromechanical device, including:

- a substrate (SS);
- a first layer ($C_1$) of a piezoelectric material, deposited on a surface of said substrate;
- a second layer ($C_2$) of a semiconductor material, deposited on said first layer;
- at least one suspended element (ES), formed by extensions of said layers extending beyond an edge (B) of said substrate;
- a field effect transistor (FET) integrated into said second layer and its extension, having at least one channel extending at least partially inside said suspended element, including electrodes (D, S, G) connected to conducting tracks (PC$_D$, PC$_S$, PC$_G$) extending above said second layer and at least one of which passes above said edge of the substrate;

**characterized in that**:

- at least two conducting tracks connected to two overlapping respective electrodes of the field effect transistor, without electrical contact with one another, so as to form a three-dimensional interconnection structure.

2.  The micro-electromechanical device according to claim 1, wherein at least one drain electrode and at least one source electrode of said field effect transistor are connected to electric tracks forming a waveguide.

3.  The micro-electromechanical device according to one of the preceding claims, also including a third layer (C$_3$), made from a third dielectric material, at least partially covering said second layer and on which at least one of said electric tracks is deposited, vias (V) being formed in said third layer to allow the interconnection of said or each electric track with the electrodes of the field effect transistor.

4.  The micro-electromechanical device according to claim 3, wherein:

- said element has a shape chosen between a beam embedded at both of its ends and a disc or plate embedded over its entire perimeter, said field effect transistor being formed at an embedded part of said element;
- the device also includes an actuator (EA) made at a part of said suspended element other than that bearing said transistor, said actuator being adapted for exciting a vibration mode of the suspended element in a direction perpendicular to the surface of said substrate; and said actuator includes electrodes in electrical contact with two opposite faces of said second layer, which is made from a piezoelectric semiconductor material.

5.  The micro-electromechanical device according to one of the preceding claims, wherein said first layer is made from a piezoelectric semiconductor material different from that making up the second layer, such that the interface between the first layer and the second layer forms a semiconducting heterostructure.

6.  The micro-electromechanical device according to claim 5, wherein said second layer is also made from a piezoelectric semiconductor material, different from that making up the first layer.

7.  The micro-electromechanical device according to one of claims 5 or 6, wherein a two-dimensional carrier gas (2DEG) is formed at the interface between the first and second layers.

8.  The micro-electromechanical device according to claim 7, wherein the first and second layers are made from different piezoelectric semiconductor materials, of type III-N or GaN.

9.  The micro-electromechanical device according to one of the preceding claims, wherein the field effect transistor includes:

- a first elongate electrode (D), extending over the suspended element in a direction substantially perpendicular to that of said edge of the substrate, connected to a central conducting track of a waveguide extending above the second layer;
- two second elongate electrodes (S$_1$, S$_2$), extending over the suspended element in a direction substantially perpendicular to that of said edge of the substrate, positioned on either side of the first electrode and connected to respective side conducting tracks of said waveguide, two channels of the transistor being defined by the first and second electrodes; and
- two elongate gate electrodes (G$_1$, G$_2$), extending over the suspended element above respective channels of the transistor, separated from the latter by insulating layers and connected to at least one conducting track overlapping, without electrical contact, at least the central track and a side track of said waveguide.

10. The micro-electromechanical device according to one of claims 1 to 8, wherein the field effect transistor includes:

- a first elongate electrode (D), extending over the suspended element in a direction substantially perpendicular to that of said edge of the substrate, connected to a central conducting track of a waveguide extending above the second layer;
- two second electrodes (S$_1$, S$_2$), formed over a portion of the second layer that extends above the surface of the substrate near the suspended element, connected to respective side conducting tracks of said waveguide, two channels of the transistor being defined by the first and second electrodes; and
- two elongate gate electrodes ($G_1$, $G_2$), extending over the suspended element above respective channels of the transistor, separated from the latter by insulating layers and connected to at least one conducting track overlapping, without electrical contact, at least the central track and a side track of said waveguide.

11. The micro-electromechanical device according to claim 2 or any one of claims 3 to 8 when it depends on claim 2, wherein the field effect transistor includes:

- a first electrode (D), made on the suspended element, connected to the central conducting track of said waveguide; and
- two second electrodes ($S_1$, $S_2$) formed on a portion of the second layer that extends above the surface of the substrate near the suspended element, connected to two side conducting tracks of a waveguide, a transistor channel being defined by said first and second electrodes.

12. The micro-electromechanical device according to claim 11, wherein the field effect transistor also includes a gate electrode (G) situated between said first and second electrodes, extending above the channel of the transistor and connected to a conducting track overlapping, without electrical contact, at least the central track of said waveguide.

13. The micro-electromechanical device according to one of claims 1 to 8, wherein the field effect transistor includes:

- a plurality of first electrodes ($D_1$, $D_2$) made on the suspended element, aligned in a direction substantially perpendicular to that of said edge of the substrate, and connected to a central conducting track of a waveguide extending above the second layer;
- a plurality of second electrodes ($S_1$, $S_2$) made on the suspended element, aligned in a direction substantially perpendicular to that of said edge of the substrate so as to alternate with the first electrodes, and connected to the side conducting tracks of a waveguide extending above the second layer; and
- a plurality of gate electrodes ($G_1$, $G_2$) situated between respective pairs of said first and second electrodes and connected to a conducting track overlapping, without electrical contact, at least one conducting track of said waveguide.

14. the micro-electromechanical device according to one of the preceding claims, wherein said suspended element (ES) includes a fundamental vibration mode of the beam in a direction perpendicular to the surface of said substrate, the resonance frequency of which is comprised between 10 MHz and 1 GHz, and preferably between 1 MHz and 100 MHz.

15. A method for using a micro-electromechanical device according to one of the preceding claims as a mechanical oscillator, including:

- applying a first potential difference ($V_{ds}$) between at least two electrodes of said transistor, one of which constitutes a drain and the other a source, the value of said potential difference being chosen so as to allow an adjustment of the resonance frequency of said oscillator; and
- detecting mechanical oscillations of said suspended element by measuring an electric current traversing a channel of said transistor.

16. the method according to claim 15, also including the application of a second potential difference ($V_{gs}$) between at least one gate electrode and said source electrode of said transistor, the values of said first and second potential differences being determined so as to maximize the ratio between the drain-source current of said transistor and the amplitude of the vibrations of said suspended element.

17. The method for using a micro-electromechanical device according to claim 4, wherein said actuator is made up of a first electrode situated above the second layer and by a second electrode making it possible to apply a potential difference to a two-dimensional carrier gas formed at the interface between the first and second layers, including:

- applying a potential difference (Vdc-act) between the two electrodes of the actuator so as to allow an adjustment of an amplitude of an oscillation of said suspended element excited by said actuator; and
- detecting mechanical oscillations of said suspended element by measuring an electric current traversing a channel of said transistor.

Fig.1A

Fig.1B

Fig.2

Fig.3A

Fig.3B

## Fig.3C

## Fig.4

Fig.5A

Fig.5B

Fig.5C

**Fig.6**

**Fig.7**

Fig.8

Fig.9A

Fig.9B

Fig.9C

Fig.9D

Fig.10

Vds=8V

Vgs=0V; Pact=0dB

Fig.11A

Vds=1V

Fig.11B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- WO 2004083110 A

- US 20070176211 A

### Littérature non-brevet citée dans la description

- **H. C. NATHANSON et al.** The resonant gate transistor. *IEEE Transactions on Electron Devices,* 1967, vol. ED-14 (3), 117
- **Y. CORDIER et al.** AlGaN/GaN HEMTs on resistive si(111) substrate grown by gas-source MBE. *Electronics Letters,* 17 Janvier 2002, vol. 38 (2), 91-92

- **V. CIMALLA ; J. PEZOLDT ; O. AMBACHER.** Group III nitride and SiC based MEMS and NEMS : materials properties, technologies and applications. *Journal of Physics D : Applied Physics,* 2007, vol. 40, 6386-6434
- **F. NIEBELSCHÜTZ et al.** AlGaN/GaN-based MEMS with two-dimensional electron gas for novel sensor applications. *Physica Status Solidi (c),* 2008, vol. 5 (6), 1914-1916